# EUROPEAN PATENT SPECIFICATION

(11) **EP 1 552 603 B1**
(45) Date of publication and mention of the grant of the patent: **01.07.2009**
(21) Application number: 03792459.4
(22) Date of filing: 06.08.2003
(51) Int. Cl.: H03F 1/02

(54) **A POWER AMPLIFIER SYSTEM**
LEISTUNGSVERSTÄRKERSYSTEM
SYSTEME AMPLIFICATEUR DE PUISSANCE

(30) Priority: 21.08.2002 GB 0219466
(43) Date of publication of application: 13.07.2005
(73) Proprietor: Nokia Siemens Networks GmbH & Co. KG, 81541 München (DE)
(72) Inventor: DOMOKOS, John, Salisbury, Wiltshire SP1 1NH (GB)
(74) Representative: Ruuskanen, Juha-Pekka
(86) International application number: PCT/GB2003/003414
(87) International publication number: WO 2004/019486

(56) References cited:
- WO-A-02/089320
- US-A- 6 028 486
- US-A1- 2001 004 387
- PATENT ABSTRACTS OF JAPAN vol. 0060, no. 60 (E-102), 17 April 1982 (1982-04-17) & JP 57 002107 A (PIONEER ELECTRONIC CORP), 7 January 1982 (1982-01-07)

## Description

This invention relates to a linear power amplifier system, in particular for use with 3^{rd} generation mobile communication systems.

Power amplifiers can be generally categorised into three modes of operation, class A, B and C. For a linear amplifier a class A or class B amplifier amplifies a sinusoidal signal, so maximum efficiency is achieved if the output is a sinewave extending over the full range of voltage and minimum efficiency is achieved if the sinewave amplitude is minimum. Class B amplifiers are biased at zero, so the output produces current pulses with half the cycle missing which is reconstituted by subsequent filtering. Class C amplifiers are negatively biased and non-linear, in this case a low signal level also leads to low efficiency.

Mobile communications systems have in the past used constant amplitude radio waves, so it was possible to adapt the amplifier design for maximum efficiency given that the signal amplitude was known. However, 2^{nd} generation multi-carrier operation and 3^{rd} generation mobile communication require linear power amplifiers to operate with amplitude-variant radio frequency (RF) signals. Therefore, the power amplifier, designed to be able to deliver the maximum peak envelope power, is usually fed with a constant voltage power supply that is dimensioned to deliver the peak power and so is highly inefficient because the instantaneous envelope power is well below the peak power most of the time. Thus, the amplifier unnecessarily dissipates excess power due to the large constant power supply voltage.

Several different methods have been cited to improve the efficiency of linear power amplifiers. One method is based on the envelope elimination and restoration (EER) technique. This method has severe bandwidth limitation and therefore is not suitable for the amplification of the broadband signals used in the current mobile communication systems.

Another method is based on the principle of the Doherty amplifier. Both the EER and the Doherty amplifiers suffer from spectral spreading effects and bandwidth limitation and so are not used in current communication systems.

US2002/0084844 describes a system in which first and second amplifier stages are provided, such that if a signal power level is below a predetermined threshold, the signal is directed to a first stage amplifier to amplify the input signal and if the level is above the threshold the signal is directed to the second stage amplifier. This system is somewhat limited in its application since it views the input signal as being simply low power or high power. Furthermore, it is inefficient in hardware terms because of the requirement to construct two amplifier stages, although only one will ever be used at any time. JP57 002107 describes an audio power amplifier designed to reduce switching distortion by adapting the power supply voltage to the input signal level.

In accordance with a first aspect of the present invention, an RF power amplifier system comprises a control circuit; a delay circuit and a power amplifier; wherein the control circuit comprises a detector for detecting an instantaneous power level of an input signal from a signal source; a threshold comparator; and a power supply voltage source; and a pulse shaping filter; wherein the threshold comparator is provided with a plurality of preset thresholds; wherein the threshold comparator compares the power level detected at the detector with the preset thresholds; wherein the power supply voltage is switched according to the output of the threshold comparator, and wherein the delay device delays the input signal to the power amplifier to enable the power supply voltage to be adapted to the power level detected at the detector, such that the efficiency of the power amplifier is optimised.

The present invention provides an efficient linear power amplifier in which the power supply voltage to the amplifier is changed according to the threshold reached by the detected input signal power level. Multiple thresholds are preset and associated with a suitable power supply voltage. This is a flexible system which provides a significant improvement in efficiency over conventional systems.

The system may be operated with two preset thresholds, but preferably, at least three preset thresholds are provided.

Preferably, the power supply voltage source comprises a plurality of preset power supply voltages associated with respective power level thresholds.

Preferably, at least four preset power supply voltages are provided.

Preferably, the power amplifier is a Class B amplifier and a filter is provided at the output of the amplifier to reconstitute the amplified input signal.

In accordance with a second aspect of the present invention, a code division multiple access (CDMA) communication system comprises a power amplifier system according to the first aspect.

CDMA systems use radio waves which have varying amplitudes, but the present invention is able to cope with this whilst maintaining efficiency of the amplifier by switching the power supply voltage according to the input signal power level.

In accordance with a third aspect of the present invention, a method of operating a power amplifier system comprises applying an input signal from a signal source, to a control circuit and a delay device; detecting at a detector in the control circuit an instantaneous power level of an input signal; comparing the detected power level with a plurality of preset thresholds in a threshold comparator, switching a power supply voltage according to the output of the threshold comparator, and passing the power supply voltage through the pulse shaping filter; wherein the delay device delays the input signal to the power amplifier to enable the power supply voltage to be adapted to the detected power level, such that the efficiency of the power amplifier is optimised.

Preferably, a plurality of power supply voltage levels, associated with respective power level thresholds, are preset.

An example of a power amplifier system in accordance with the present invention will now be described with reference to the accompanying drawings in which:
Figure is an example of a power supply system according to the present invention;
Figure 2 illustrates variation in input power for an input signal using the system of Fig. 1; and
Figure 3 illustrates the corresponding variation in power supply voltage for the power amplifier of the system of Fig. 1.

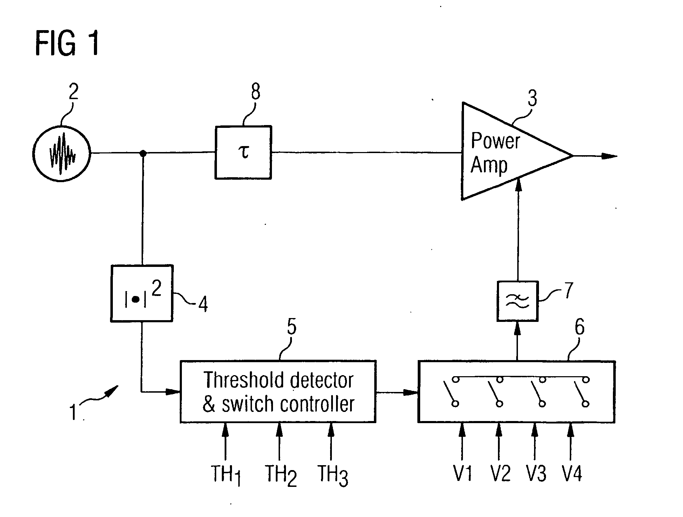

Figure 1 shows one example of a power amplifier system 1 according to the present invention. An amplitude variant source signal 2, containing information that is to be transmitted, is input to the system. The signal follows a first path to a power amplifier 3 via a control circuit. The control circuit comprises an envelope detector 4, which provides a value that is proportional to the instantaneous power of the input signal 2. This value is applied to a threshold detector 5 which has N, in this case 3, preset thresholds, although more can be set if appropriate. An output of the threshold detector 5 controls switching of a switch unit 6 between N+1, in this case 4, discrete power supply voltages for the power amplifier. The chosen voltage then passes through a pulse shaping filter 7 to the power amplifier 3. The signal follows a second path to the power amplifier via a time delay 8, so that the power supply voltage of the power amplifier is set to the correct value before the signal to which it relates is amplified in the power amplifier 3.

In operation, the threshold detector 5 compares pre-set threshold values TH₁, TH₂, and TH₃ with the value representing the instantaneous power provided by the envelope detector 4. The output of this comparison provides a control signal to turn the appropriate switch on in the switch unit 6. In this example, if the instantaneous envelope of the signal 2 is below threshold TH₁, then a voltage V₁ is applied to the power amplifier 3. If the envelope is between thresholds TH₁ and TH₂, then a voltage V₂ is applied to the power amplifier; if the envelope is between thresholds TH₂ and TH₃, then a voltage V₃ is applied to the power amplifier and finally, for all envelope values above the pre-set threshold TH₃, a voltage, V₄ is selected by the switch unit 6.

It should be noted that the invention is not restricted to three discrete threshold values, and in fact any number may be used. The number of pre-set threshold values and the corresponding supply voltages are determined to match the properties of the transmitted signal and the characteristics of the power amplifier.

A further feature of the present invention is the provision of the pulse-shaping filter 7. This filter limits the slew rate of the power supply voltage as the DC voltage is switched between the discrete values. This in turn minimizes the undesirable spectral spreading of the transmitted signal that may be caused by the power amplifier as the supply voltage is varied.

The purpose of the time delay 8 in the second path is to match the overall delay in the first path containing the envelope detector 4, the threshold detector 5, the switch unit 6 and the pulse-shaping filter 7 with the delay of the power amplifier. This ensures that the signal and the appropriate power supply voltage are applied synchronously at the correct instant.

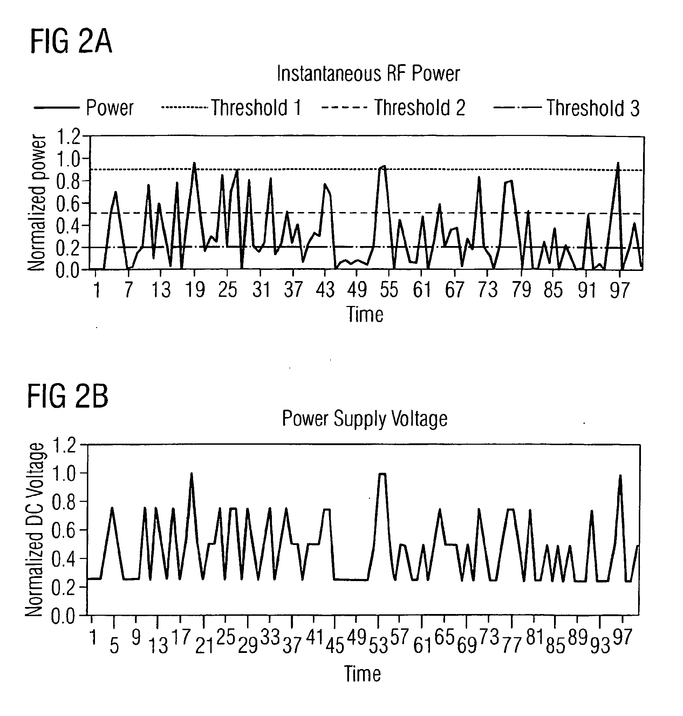

Fig. 2a illustrates an example of how the instantaneous power determined in the envelope detector 4 varies for a particular input signal. The graph shows normalised power against time and three thresholds TH₁, TH₂ and TH₃ for the normalised power are set, at values of 0.9, 0.5 and 0.2 respectively. From Fig. 2b it is possible to see how the power supply voltage changes with each threshold transition. A normalised DC voltage is shown against time. It takes a finite period of time to reach the new value, hence the need to delay the signal into the power amplifier, so that the power supply voltage is correct.

The time delay 8, envelope detector 4 and threshold detector 5 may be implemented digitally in the baseband section of a transmitter or alternatively these elements may be realized by analog circuitry. The efficiency improvement described herein is applicable in conjunction with both feed forward and pre-distortion linearisation techniques.

## Claims

1. An RF power amplifier system, the system comprising a control circuit (1); a delay circuit (8) and an RF power amplifier (3); wherein the control circuit comprises a detector (4) for detecting an instantaneous power level of an input signal from a signal source (2); a threshold comparator (5); a power supply voltage source (6); and a pulse shaping filter (7); wherein the threshold comparator is provided with a plurality of preset thresholds (TH₁, TH₂, TH₃); wherein the threshold comparator (5) compares the power level detected at the detector (4) with the preset thresholds; wherein the power supply voltage is switched according to the output of the threshold comparator (5); and wherein the delay device (8) delays the input signal to the power amplifier (3) to enable the power supply voltage to be adapted to the power level detected at the detector (4), such that the efficiency of the power amplifier is optimised.

2. A power amplifier system according to claim 1, wherein at least three preset thresholds (TH₁, TH₂, TH₃) are provided.

3. A power amplifier system according to claim 1 or claim 2, wherein the power supply voltage source (6) comprises a plurality of preset power supply voltages (V1, V2, V3, V4) associated with respective power level thresholds (TH₁, TH₂, TH₃).

4. A power amplifier system according to claim 3, wherein at least four preset power supply voltages (V1, V2, V3, V4) are provided.

5. A power amplifier system according to any preceding claim, wherein the power amplifier (3) is a Class B amplifier and wherein a filter is provided at the output of the amplifier to reconstitute the amplified input signal.

6. A CDMA communication system comprising a power amplifier system according to any preceding claim.

7. A method of operating a power amplifier system, the method comprising applying an input signal from a signal source (2) to a control circuit (1) and a delay device (8); detecting at a detector (4) in the control circuit (1) an instantaneous power level of an input signal; comparing the detected power level with a plurality of preset thresholds (TH₁, TH₂, TH₃) in a threshold comparator (5); switching a power supply voltage (V1, V2, V3, V4) according to the output of the threshold comparator; and passing the power supply voltage through a pulse shaping filter (7); wherein the delay device (8) delays the input signal to the power amplifier (3) to enable the power supply voltage to be adapted to the detected power level, such that the efficiency of the power amplifier is optimised.

8. A method according to claim 7, wherein a plurality of power supply voltage levels (V1, V2, V3, V4) associated with respective power level thresholds (TH₁, TH₂, TH₃) are preset.

## Patentansprüche

1. HF-Leistungsverstärkersystem, wobei das System Folgendes umfasst: eine Steuerschaltung (1); eine Verzögerungsschaltung (8) und einen HF-Leistungsverstärker (3); wobei die Steuerschaltung Folgendes umfasst: einen Detektor (4) zum Detektieren eines Momentanleistungspegels eines Eingangssignals aus einer Signalquelle (2); einen Schwellenkomparator (5); eine Stromversorgungsspannungsquelle (6); und ein Impulsformungsfilter (7); wobei der Schwellenkomparator mit mehreren voreingestellten Schwellen (TH₁, TH₂, TH₃) ausgestattet ist; wobei der Schwellenkomparator (5) den in dem Detektor (4) detektierten Leistungspegel mit den voreingestellten Schwellen vergleicht; wobei die Stromversorgungsspannung gemäß der Ausgabe des Schwellenkomparators (5) umgeschaltet wird; und wobei die Verzögerungseinrichtung (8) das Eingangssignal des Leistungsverstärkers (3) verzögert, um eine Anpassung der Stromversorgungsspannung an den in dem Detektor (4) detektierten Leistungspegel zu ermöglichen, so dass der Wirkungsgrad des Leistungsverstärkers optimiert wird.

2. Leistungsverstärkersystem nach Anspruch 1, wobei mindestens drei voreingestellte Schwellen (TH₁, TH₂, TH₃) vorgesehen sind.

3. Leistungsverstärkersystem nach Anspruch 1 oder Anspruch 2, wobei die Stromversorgungsspannungsquelle (6) mehrere voreingestellte Stromversorgungsspannungen (V1, V2, V3, V4) umfasst, die mit jeweiligen Leistungspegelschwellen (TH₁, TH₂, TH₃) assoziiert sind.

4. Leistungsverstärkersystem nach Anspruch 3, wobei mindestens vier voreingestellte Stromversorgungsspannungen (V1, V2, V3, V4) vorgesehen sind.

5. Leistungsverstärkersystem nach einem der vorhergehenden Ansprüche, wobei der Leistungsverstärker (3) ein Verstärker der Klasse B ist und wobei am Ausgang des Verstärkers ein Filter vorgesehen ist, um das verstärkte Eingangssignal zu rekonstituieren.

6. CDMA-Kommunikationssystem, das ein Leistungsverstärkersystem nach einem der vorherigen Ansprüche umfasst.

7. Verfahren zum Betrieb eines Leistungsverstärkersystem mit den folgenden Schritten: Anlegen eines Eingangssignals aus einer Signalquelle (2) an eine Steuerschaltung (1) und eine Verzögerungseinrichtung (8); Detektieren eines Momentanleistungspegels eines Eingangssignals in einem Detektor (4) in der Steuerschaltung (1); Vergleichen des detektierten Leistungspegels mit mehreren voreingestellten Schwellen (TH₁, TH₂, TH₃) in einem Schwellenkomparator (5); Umschalten einer Stromversorgungsspannung (V1, V2, V3, V4) gemäß der Ausgabe des Schwellenkomparators; und Leiten der Stromversorgungsspannung durch ein Impulsformungsfilter (7); wobei die Verzögerungseinrichtung (8) das Eingangssignal des Leistungsverstärkers (3) verzögert, um eine Anpassung der Stromversorgungsspannung an den detektierten Leistungspegel zu ermöglichen, so dass der Wirkungsgrad des Leistungsverstärkers optimiert wird.

8. Verfahren nach Anspruch 7, wobei mehrere Stromversorgungsspannungspegel (V1, V2, V3, V4) voreingestellt werden, die mit jeweiligen Leistungspegelschwellen (TH₁, TH₂, TH₃) assoziiert sind.

## Revendications

1. Système d'amplificateur de puissance RF, le système comprenant un circuit de commande (1) ; un circuit de retard (8) et un amplificateur de puissance RF (3) ; dans lequel le circuit de commande comprend un détecteur (4) pour détecter un niveau de puissance instantanée d'un signal d'entrée provenant d'une source de signal (2) ; un comparateur de seuil (5) ; une source de tension d'alimentation électrique (6) ; et un filtre de mise en forme d'impulsions (7) ; dans lequel le comparateur de seuil est prévu avec une pluralité de seuils prédéfinis (TH₁, TH₂, TH₃) ; dans lequel le comparateur de seuil (5) compare le niveau de puissance détecté au niveau du détecteur (4) avec les seuils prédéfinis ; dans lequel la tension d'alimentation électrique est activée en fonction de la sortie du comparateur de seuil (5) ; et dans lequel le dispositif de retard (8) retarde le signal d'entrée vers l'amplificateur de puissance (3) pour permettre que la tension d'alimentation électrique soit adaptée au niveau de puissance détecté au niveau du détecteur (4), de sorte que l'efficacité de l'amplificateur de puissance est optimisée.

2. Système d'amplificateur de puissance selon la revendication 1, dans lequel au moins trois seuils prédéfinis (TH₁, TH₂, TH₃) sont prévus.

3. Système d'amplificateur de puissance selon la revendication 1 ou la revendication 2, dans lequel la source de tension d'alimentation électrique (6) comprend une pluralité de tensions d'alimentation électrique prédéfinies (V1, V2, V3, V4) associées avec des seuils de niveau de puissance (TH₁, TH₂, TH₃) respectifs.

4. Système d'amplificateur de puissance selon la revendication 3, dans lequel au moins quatre tensions d'alimentation électrique prédéfinies (V1, V2, V3, V4) sont prévues.

5. Système d'amplificateur de puissance selon une quelconque revendication précédente, dans lequel l'amplificateur de puissance (3) est un amplificateur de Classe B et dans lequel un filtre est prévu à la sortie de l'amplificateur pour reconstituer le signal d'entrée amplifié.

6. Système de communication CDMA comprenant un système d'amplificateur de puissance selon une quelconque revendication précédente.

7. Procédé d'utilisation d'un système d'amplificateur de puissance, le procédé comprenant l'application d'un signal d'entrée provenant d'une source de signal (2) à un circuit de commande (1) et un dispositif de retard (8) ; la détection au niveau d'un détecteur (4) dans le circuit de commande (1) d'un niveau de puissance instantanée d'un signal d'entrée ; la comparaison du niveau de puissance détecté avec une pluralité de seuils prédéfinis (TH₁, TH₂, TH₃) dans un comparateur de seuil (5) ; l'activation d'une tension d'alimentation électrique (V1, V2, V3, V4) en fonction de la sortie du comparateur de seuil ; et le passage de la tension d'alimentation électrique à travers un filtre de mise en forme d'impulsions (7) ; dans lequel le dispositif de retard (8) retarde le signal d'entrée vers l'amplificateur de puissance (3) pour permettre que la tension d'alimentation électrique soit adaptée au niveau de puissance détecté, de sorte que l'efficacité de l'amplificateur de puissance est optimisée.

8. Procédé selon la revendication 7, dans lequel une pluralité de niveaux de tension d'alimentation électrique (V1, V2, V3, V4) associés avec des seuils de niveau de puissance (TH₁, TH₂, TH₃) respectifs sont prédéfinis.
